# EUROPEAN PATENT SPECIFICATION

(11) **EP 3 335 828 B1**
(45) Date of publication and mention of the grant of the patent: **01.01.2025**
(21) Application number: 17201231.2
(22) Date of filing: 13.11.2017
(51) Int. Cl.: B23K 35/26, C22C 13/00, B23K 103/08, B32B 9/00, B32B 1/00, B32B 7/10, B32B 7/12, B32B 9/04, B32B 15/04, B32B 15/20, H01L 23/373, H01L 21/48

(54) **MANUFACTURING METHOD OF BONDED BODY AND BONDED BODY OBTAINED BY THE SAME**
VERFAHREN ZUR HERSTELLUNG EINES VERBUNDKÖRPERS UND NACH DIESEM VERFAHREN HERGESTELLTER VERBUNDKÖRPER
MÉTHODE DE FABRICATION D'UN CORPS LIÉ ET CORPS LIÉ OBTENU PAR CETTE MÉTHODE

(30) Priority: 06.12.2016 JP 2016237027
(43) Date of publication of application: 20.06.2018
(73) Proprietor: Panasonic Intellectual Property Management Co., Ltd., Osaka-shi, Osaka 540-6207 (JP)
(72) Inventor: KITAURA, Hidetoshi, Osaka 540-6207 (JP); SAKAGUCHI, Shigeki, Osaka 540-6207 (JP)
(74) Representative: Vigand, Philippe

(56) References cited:
- EP-A1- 1 080 824
- EP-A1- 1 106 301
- WO-A2-2015/004467
- JP-A- H0 195 893
- US-A- 3 361 561
- US-A- 3 484 210
- US-A- 4 797 328
- US-B1- 6 231 693

## Description

### BACKGROUND

### 1. Technical Field

The invention relates to a manufacturing method of bonded body and a bonded body obtained by using the same.

### 2. Description of the Related Art

For example, a ceramic-carbon composite which has a plurality of carbon particles and a ceramics portion is known as a bonding material for bonding a carbon material and another member (Japanese Patent Unexamined Publication No. 2012-246172). Specifically, aluminum nitride or silicon carbide is used in the ceramics portion of the ceramic-carbon composite. The ceramic-carbon composite can be bonded to a metal material by being baked, for example, through heating at 1700°C to 2100°C and pressing. In addition, a bonded body which is configured from graphite and is to be bonded to a copper plate or the like by using an insert material which is configured from silver, copper, and titanium is also known (Japanese Patent No. 5930604). The bonded body disclosed in Japanese Patent No. 5930604 is a bonded body which has a plate shape and is obtained by stacking graphene sheets. The bonded body can be bonded to a member which is to be bonded, by performing pressing in a state where an insert material is interposed between the member to be bonded and the bonded body. US3361561A and US3484210A describe alloys for soldering conductors to carbon and graphite.

### SUMMARY

According to the invention, a manufacturing method of a bonded body is provided as defined in claim 1.

According to the invention, a bonded body is provided as defined in claim 2.

### BRIEF DESCRIPTION OF THE DRAWINGS

FIG. 1A is a diagram illustrating a manufacturing method of a bonded body;
FIG. 1B is a diagram illustrating the manufacturing method of a bonded body;
FIG. 2A is a diagram illustrating an electron microscope image of a section of the bonded body;
FIG. 2B is a diagram illustrating a change in concentration of each element with a change of a position in a direction perpendicular to a direction in which each layer is expanded, on the electron microscope image of the section of the bonded body; and
FIG. 3 is a schematic diagram illustrating a device for an evaluation test of heat conductivity and flexibility.

### DETAILED DESCRIPTION

Ahead of describing exemplary embodiments, problems in the related art will be briefly described.

It is necessary that carbon bonded by the bonding material disclosed in Japanese Patent Unexamined Publication No. 2012-246172 is included in the bonding material in a particulate form. Thus, it is difficult to bond, for example, a carbon material formed to have a plate shape, to another member by the bonding material disclosed in Japanese Patent Unexamined Publication No. 2012-246172. Further, a metal material and carbon particles are bonded to each other by baking the carbon particles and a ceramics portion at a high temperature. Thus, there is a problem in that a ceramic-carbon composite after baking (that is, after bonding) has poor flexibility.

In addition, it is difficult to deform a bonded structure which uses the bonded body disclosed in Japanese Patent No. 5930604 because of the high Young modulus (silver: 100 GPa, copper: 136 GPa) of an insert material which is configured from silver, copper, and titanium. Thus, high stress may be applied to a junction by heat shrinkage at a time of cooling in a manufacturing process, and thus cracks may occur.

To solve the above problems, an object of the disclosure is to provide a bonding material which can fix members having any shape to each other, particularly can be bonded to a carbon material, and can form a junction having flexibility.

According to the disclosure, a bonding material includes at least 0.1 wt% to at most 5 wt% of at least one element (compound-formable element) which may form a compound along with tin and carbon, and Sn as the main component of a remainder.

"At least one element (compound-formable element) which may form a compound along with tin and carbon" in the disclosure means any element for forming a compound along with tin and carbon. When two kinds or more of compound-formable elements are provided, the content percentage (wt%) of the compound-formable element in the bonding material indicates a percentage of the sum of the weights of the two kinds or more of compound-formable elements included in the bonding material, to the total weight of the bonding material.

In the disclosure, "the main component" means an element having highest abundance percentage among elements in the bonding material.

In a bonding material according to an exemplary embodiment, a compound-formable element includes at least one of titanium, zirconium, and vanadium.

In a manufacturing method of a bonded body according to the exemplary embodiment, a first member and a second member are prepared, and the first member and the second member are bonded to each other by using the bonding material. Thus, a bonded body is provided.

In the disclosure, "the first member" and "the second member" mean bonded members which are fixed to each other by the bonding material.

In the manufacturing method of a bonded body in the exemplary embodiment, at least one of the first member and the second member is a carbon material. When the first member and the second member are bonded to each other, a compound layer configured from a compound of the compound-formable element, tin, and carbon is formed at an interface between the bonding material and the carbon material.

In the disclosure, "the carbon material" means a bonded member which is fixed by the bonding material, has any shape, and is made of carbon.

In the manufacturing method of a bonded body in the exemplary embodiment, all of the first member and the second member are carbon materials. When the first member and the second member are bonded to each other, the compound layer configured from a compound of the compound-formable element, tin, and carbon is formed at the interface between the bonding material and the carbon material.

A bonded body according to the exemplary embodiment is a bonded body which includes a first member, a second member, and a junction provided between the first member and the second member. Each of the first member and the second member is a carbon material, and a compound layer including the compound-formable element is formed at an interface between the carbon material and the junction.

The bonded body according to the exemplary embodiment is a bonded body which includes a first member, a second member, and a junction provided between the first member and the second member. In the bonded body, all of the first member and the second member are carbon materials, and the compound layer including the compound-formable element is provided at the interface between the carbon material and the junction.

In the bonded body in the exemplary embodiment, the compound-formable element includes at least one of titanium, zirconium, and vanadium. Hereinafter, the bonding material as the exemplary embodiment of the disclosure will be described with reference to the drawings.

### Bonding Material

In the disclosure, the bonding material is an alloy which contains at least 0.1 wt% to at most 5 wt% of a compound-formable element and tin as the main component of the remainder.

The compound-formable element is not particularly limited so long as the element is an element which can form a compound along with both of tin and carbon. For example, titanium, zirconium, and vanadium may be used.

The content of the compound-formable element in the bonding material is equal to or greater than 0.1 wt%. Thus, in a case where the bonded member is a carbon material, the sufficient amount of a compound is formed at an interface between a junction and the bonded member (first member and second member). Accordingly, favorable bonding with high tensile strength can be performed at the interface between the junction and the bonded member. The content of the compound-formable element in the bonding material is equal to or smaller than 5 wt%. Thus, it is possible to prevent deterioration of heat conductivity at the junction which is formed by using the bonding material, and to prevent an occurrence of cracks in a compound layer formed between the junction and the bonded member in a case where the bonded member is a carbon material.

The remainder of the bonding material is configured from only tin. At this time, if one kind of compound-formable element is included in the bonding material, the bonding material is a two-element alloys configured from the one kind of compound-formable element and tin as the main component. The remainder of the bonding material may be configured from plural kinds of elements which includes tin as the main component. At this time, the bonding material is a multi-element alloy configured from the compound-formable element and the plural kinds of elements which includes tin as the main component.

A bonded body and a manufacturing method thereof according to the exemplary embodiment of the disclosure will be described below with reference to the drawings.

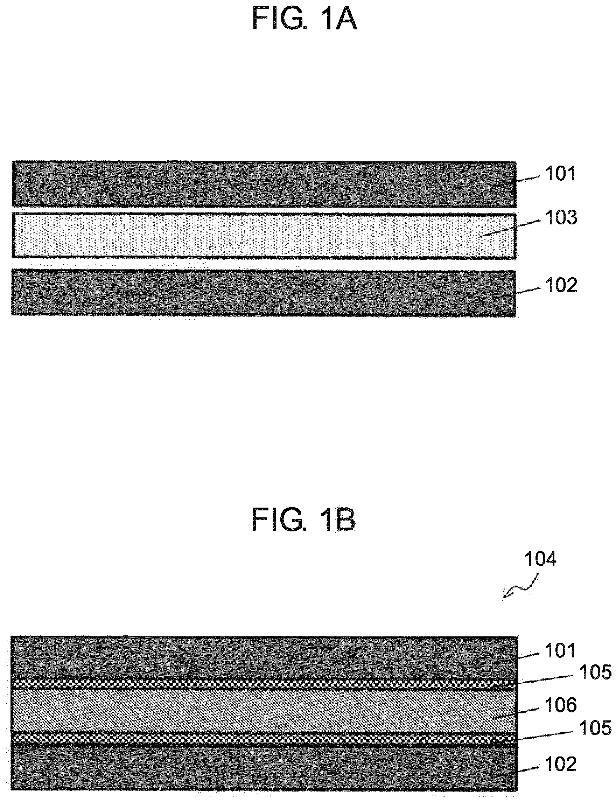

Firstly, as illustrated in FIG. 1A, first member 101, second member 102, and bonding material 103 are prepared.

First member 101 and second member 102 are carbon materials which are fixed to each other by the bonding material. In the exemplary embodiment illustrated in FIG. 1A, first member 101 and second member 102 are carbon materials. However, a member fixed by the bonding material may be a member formed by copper, nickel, aluminum, or the like. The reason that the various types of bonded members as described above may be obtained is because tin as the main component of bonding material 103 may cause an interface reaction with various types of metal. First member 101 and second member 102 may be any carbon materials. For example, a highly-aligned graphite sheet, an expanded graphite sheet, and an isotropic graphite may be used. However, it is not limited thereto.

It is preferable that first member 101 and second member 102 have heat conductivity of 400 W/m·K or greater. Since first member 101 and second member 102 have such heat conductivity, it is possible to use a bonded body to be formed, as a heat spreader.

Regarding easiness in manufacturing, first member 101 and second member 102 preferably have a vertical length of 200 mm or smaller, a horizontal length of 200 mm or smaller, and a thickness of 0.5 mm or smaller. However, it is not limited thereto, and first member 101 and second member 102 may have various kinds of dimensions.

The shape of bonding material 103 is a film shape. The thickness of bonding material 103 is preferably equal to or greater than 0.01 mm. Since the bonding material has such a thickness, first member 101 and second member 102 can be bonded to each other without a gap.

Then, while pressure is applied to first member 101, second member 102, and bonding material 103 illustrated in FIG. 1A so as to cause a junction which is to be obtained to have a desired thickness, hot pressing is performed on first member 101, second member 102, and bonding material 103 under an atmosphere of nitrogen over some time. Then, cooling is performed. Thus, as illustrated in FIG. 1B, bonded body 104 which includes first member 101, second member 102, and a junction is formed. The junction is configured by bonding material layer 106 and compound layer 105.

A temperature for performing the hot pressing is variously selected in accordance with the type and the percentage of an element contained in the bonding material. However, this temperature may be equal to or higher than a melting point of bonding material 103, and, is 250°C to 1500°C. A time for performing the hot pressing is variously selected in accordance with the type and the percentage of an element contained in the bonding material. However, for example, 10 minutes may be provided.

The junction is formed by performing hot pressing on bonding material 103, and is configured from bonding material layer 106 and compound layer 105.

Compound layer 105 is a portion of the junction, and is provided at an interface between the first member 101 and the junction and between the second member 102 and the junction. Compound layer 105 is configured from a compound of the compound-formable element, tin, and carbon. Since such compound layer 105 is provided at the junction, first member 101 and second member 102 are significantly firmly bonded to each other at an atomic level by the junction, and thus it is possible to improve strength of bonded body 104.

Concentration of the compound-formable element in compound layer 105 is higher than concentration of the compound-formable element in bonding material 103. This is because the compound-formable element contained in bonding material 103 is thickened toward compound layer 105 when bonded body 104 is formed. A composition of compound layer 105 is variously selected in accordance with the type and the percentage of an element contained in bonding material 103. However, it is preferable that compound layer 105 includes about 50 wt% to 80 wt% of the compound-formable element, 1 wt% to 15 wt% of tin, and 5 wt% to 49 wt% of carbon.

The thickness of compound layer 105 is 0.1 µm to 10µm, and preferably 0.1 µm to 6 µm. Since the thickness of compound layer 105 is equal to or greater than 0.1 µm, the bonded member and the junction are bonded to each other by the sufficient amount of the compound which includes the compound-formable element, tin, and carbon. Thus, bonded body 104 has favorable bonding properties with high tensile strength. Since the thickness of compound layer 105 is equal to or smaller than 10 µm, compound layer 105 follows deformation of the bonded body 104. Thus, it is difficult to damage bonded body 104.

Bonding material layer 106 is a portion of the junction. At this portion, a situation in which the element included in first member 101 and second member 102 is diffused toward bonding material 103 when bonded body 104 is formed, does not occur. Compound-formable element contained in bonding material 103 is thickened toward compound layer 105 when bonded body 104 is formed. Therefore, the concentration of tin in bonding material layer 106 is further higher than the concentration of tin in bonding material 103 which includes tin as the main component. As described above, since bonding material layer 106 includes tin which is metal having the Young modulus of 61 GPa, as the main component, bonding material layer 106 is much softer than general ceramics. Since such bonding material layer 106 is provided at the junction, first member 101 and second member 102 are bonded to each other by the flexible junction, and thus it is possible to effectively reduce the degree of damage such as cracks in bonded body 104.

The bonded body in the disclosure was manufactured as will be described in the following Examples 1 to 12.

### Example 1

Highly-aligned graphite which had a vertical length of 200 mm, a horizontal length of 200 mm, and a thickness of 0.1 mm was used in first member 101 and second member 102. A film obtained by performing processing with an alloy which contains 0.1 wt% of titanium as the compound-formable element and tin as the remainder was used as bonding material 103. The film was processed to have a vertical length of 200 mm, a horizontal length of 200 mm, and a thickness of 0.01 mm.

Firstly, bonding material 103 was disposed between first member 101 and second member 102. Then, while pressing pressure was controlled in a heating furnace so as to cause the thickness of junction 107 to be 0.01 mm, hot pressing was performed at 550°C for 10 minutes. Finally, natural cooling was performed, and thereby bonded body 104 was manufactured.

### Example 2

Bonded body 104 was manufactured under conditions similar to those in Example 1 except that a film obtained by performing processing with an alloy which contains 2 wt% of titanium as the compound-formable element and tin as the remainder was used as bonding material 103. The film was processed to have a vertical length of 200 mm, a horizontal length of 200 mm, and a thickness of 0.01 mm.

### Example 3

The same as those in Example 1 were used as first member 101 and second member 102. A film obtained by performing processing with an alloy which contains 5 wt% of titanium as the compound-formable element and tin as the remainder was used as bonding material 103. The film was processed to have a vertical length of 200 mm, a horizontal length of 200 mm, and a thickness of 0.015 mm.

Firstly, bonding material 103 was disposed between first member 101 and second member 102. Then, while pressing pressure was controlled in a heating furnace so as to cause the thickness of the junction to be 0.015 mm, hot pressing was performed at 550°C for 10 minutes. Finally, natural cooling was performed, and thereby bonded body 104 was manufactured.

### Example 4

Bonded body 104 was manufactured under conditions similar to those in Example 1 except that highly-aligned graphite which had a vertical length of 200 mm, a horizontal length of 200 mm, and a thickness of 0.5 mm was used in first member 101 and second member 102.

### Example 5

Bonded body 104 was manufactured under conditions similar to those in Example 4 except that a film obtained by performing processing with an alloy which contains 1 wt% of titanium as the compound-formable element and tin as the remainder was used as bonding material 103. The film was processed to have a vertical length of 200 mm, a horizontal length of 200 mm, and a thickness of 0.01 mm.

### Example 6

Bonded body 104 was manufactured under conditions similar to those in Example 4 except that a film obtained by performing processing with an alloy which contains 5 wt% of titanium as the compound-formable element and tin as the remainder was used as bonding material 103. The film was processed to have a vertical length of 200 mm, a horizontal length of 200 mm, and a thickness of 0.01 mm.

### Example 7

Bonded body 104 was manufactured under conditions similar to those in Example 1 except that a film obtained by performing processing with an alloy which contains 0.1 wt% of zirconium as the compound-formable element and tin as the remainder was used as bonding material 103. The film was processed to have a vertical length of 200 mm, a horizontal length of 200 mm, and a thickness of 0.01 mm.

### Example 8

The same as those in Example 4 were used as first member 101 and second member 102. A film obtained by performing processing with an alloy which contains 5 wt% of vanadium as the compound-formable element and tin as the remainder was used as bonding material 103. The film was processed to have a vertical length of 200 mm, a horizontal length of 200 mm, and a thickness of 0.015 mm.

Firstly, bonding material 103 was disposed between first member 101 and second member 102. Then, while pressing pressure was controlled in a heating furnace so as to cause the thickness of the junction to be 0.015 mm, hot pressing was performed at 550°C for 10 minutes. Finally, natural cooling was performed, and thereby bonded body 104 was manufactured.

### Example 9

Bonded body 104 was manufactured under conditions similar to those in Example 1 except that a film obtained by performing processing with an alloy which contains 0.5 wt% of titanium and 0.5 wt% of zirconium as the compound-formable element, and tin as the remainder was used as bonding material 103. The film was processed to have a vertical length of 200 mm, a horizontal length of 200 mm, and a thickness of 0.01 mm.

### Example 10

Bonded body 104 was manufactured under conditions similar to those in Example 1 except that a film obtained by performing processing with an alloy which contains 0.05 wt% of titanium and 0.05 wt% of vanadium as the compound-formable element, and tin as the remainder was used as bonding material 103. The film was processed to have a vertical length of 200 mm, a horizontal length of 200 mm, and a thickness of 0.01 mm.

### Example 11

Bonded body 104 was manufactured under conditions similar to those in Example 3 except that a film obtained by performing processing with an alloy which contains 2.5 wt% of zirconium and 2.5 wt% of vanadium as the compound-formable element, and tin as the remainder was used as bonding material 103. The film was processed to have a vertical length of 200 mm, a horizontal length of 200 mm, and a thickness of 0.015 mm.

### Example 12

Bonded body 104 was manufactured under conditions similar to those in Example 1 except that a film obtained by performing processing with an alloy which contains 1 wt% of titanium, 1 wt% of zirconium, and 1 wt% of vanadium as the compound-formable element, and tin as the remainder was used as bonding material 103. The film was processed to have a vertical length of 200 mm, a horizontal length of 200 mm, and a thickness of 0.01 mm.

### Comparative Example 1

Highly-aligned graphite having a vertical length of 200 mm, a horizontal length of 200 mm, and a thickness of 0.2 mm was prepared as a comparative example.

### Comparative Example 2

Highly-aligned graphite having a vertical length of 200 mm, a horizontal length of 200 mm, and a thickness of 1 mm was prepared as a comparative example.

### Comparative Example 3

Bonded body 104 was manufactured under conditions similar to those in Example 1 except that a film obtained by performing processing with an alloy which contains 0.05 wt% of titanium as the compound-formable element and tin as the remainder was used as bonding material 103. The film was processed to have a vertical length of 200 mm, a horizontal length of 200 mm, and a thickness of 0.01 mm.

### Comparative Example 4

Bonded body 104 was manufactured under conditions similar to those in Example 3 except that a film obtained by performing processing with an alloy which contains 5.5 wt% of titanium as the compound-formable element and tin as the remainder was used as bonding material 103. The film was processed to have a vertical length of 200 mm, a horizontal length of 200 mm, and a thickness of 0.015 mm.

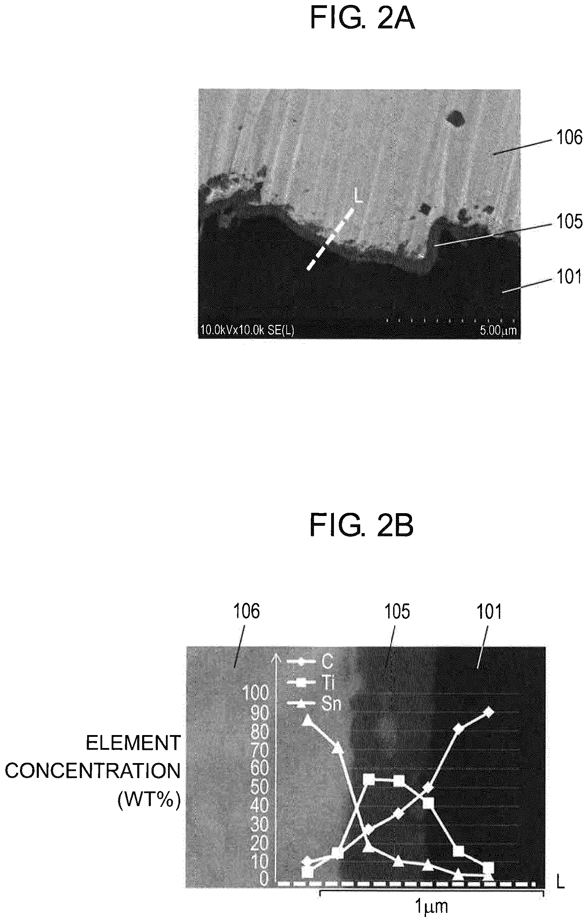

Bonded bodies 104 created in Examples 1 to 12 and Comparative Examples 3 to 4 were evaluated in a manner that a section was observed by an electron microscope. FIG. 2A illustrates an electron microscope image of a section of the bonded body manufactured in Example 1 in the disclosure. It is understood that first member 101 and bonding material layer 106 are reliably bonded to each other, because one compound layer 105 is substantially uniformly formed at the interface between first member 101 and bonding material layer 106.

In addition, element analysis was performed on a portion of the section observed by the electron microscope, and a change of concentration of each element with a change of a position in a direction perpendicular to a direction in which each layer was expanded was examined. FIG. 2B is a diagram obtained by plotting an element analysis result for a portion corresponding to a broken line indicated by L in FIG. 2A, on the electron microscope image. It was detected that the percentage of tin (Sn) was highest in bonding material layer 106. Compound layer 105 of bonded body 104 had a thickness of 0.4 µm. A composition ratio of compound layer 105 satisfied titanium/tin/carbon = 55 wt%/10 wt%/35 wt%. Thus, it was confirmed that a compound including three elements was formed in compound layer 105.

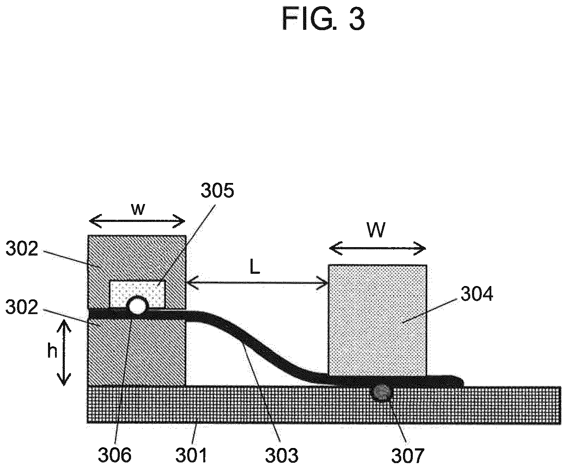

Then, heat conductivity and flexibility of bonded bodies 104 created in Example 1 to 12 and Comparative Example 3 to 4 were evaluated, and heat conductivity of highly-aligned graphite prepared in Comparative Example 1 to 2 was evaluated. The evaluation was performed by using a tester illustrated in FIG. 3. Firstly, a sample manufactured in each of the examples and the comparative examples was cut out to have a rectangular shape of 40 mm in length and 10 mm in width. This is used as replica obtained by replicating a shape when being disposed as a heat spreader, on a board. Evaluation was performed in a state where bonded body sample 303 fixed to flat plate 301 by fixing jig 302 was pushed onto flat plate 301 by holding jig 304. Heating element 305 is provided in upper fixing jig 302, and an input temperature is measured by thermocouple 306 for measuring an input temperature at an interface between heating element 305 and bonded body sample 303. In this evaluation, temperature control of the heating element was performed such that the input temperature of the thermocouple 306 for measuring an input temperature was set to be 55°C. The temperature of bonded body sample 303, which was increased by transfer of heat from heating element 305 was measured by thermocouple 307 for measuring a transfer temperature, and the measured temperature was used as a transfer temperature. Heat conductivity was evaluated by calculating a difference between the transfer temperature and the input temperature. A test was performed while holding jig 304 was cooled at a flow rate of 1 liter/min by using water of 25°C.

An object having a width of 10 mm, a depth of 10 mm, and a height of 2 mm was used as fixing jig 302. An object having a width of 10 mm, a depth of 10 mm, and a height of 15 mm was used as holding jig 304. A distance L between an end portion of fixing jig 302 and an end portion of holding jig 304 was 15 mm. An object having a width of 5 mm, a depth of 5 mm, and a height of 3 mm was used as heating element 305. Heating element 305 was installed at the center of upper fixing jig 302 on the lower surface. Thermocouple 306 for measuring an input temperature was installed on the surface at the center of heating element 305 on the lower surface. Thermocouple 307 for measuring a transfer temperature was installed so as to interpose bonded body sample 303 between the center of holding jig 304 on the lower surface and thermocouple 307 for measuring a transfer temperature.

Table 1 shows the thickness of the compound layer in each of Examples 1 to 12 and Comparative Examples 1 to 4, the composition ratio of the compound layer, and test results and evaluation results of heat conductivity and flexibility, which were obtained by the above test and the above observation.

The heat conductivity was determined based on a decrease rate of the heat conductivity. The decrease rate was calculated from a temperature difference which was measured by performing the above test on highly-aligned graphite in Comparative Examples 1 and 2 in which the bonding material was not used, and a temperature difference as the test result in each of the examples. If described by using Example 1 as an example, the decrease rate of the heat conductivity refers to a percentage of a difference between the temperature difference in Example 1 and the temperature difference in Comparative Example 1, to the temperature difference of highly-aligned graphite in Comparative Example 1. The decrease rate of the heat conductivity is calculated to be (12.7-12)/12×100=5.8%. The highly-aligned graphite in Comparative Example 1 has the same thickness as the sum of the thickness of first member 101 and second member 102 in Example 1.

A case where the decrease rate was equal to or smaller than 10% was set to be "A". A case where the decrease rate was greater than 10% and smaller than 16% was set to be "B". A case where the decrease rate was equal to or greater than 16% was set to be "C". In a case where the determination is "A", the bonded body has sufficient heat dissipation properties and does not cause degradation of performance of a CPU even when being used as a heat dissipation member, in a product. In a case where the determination is "B", degradation of performance of a CPU does not occur, but the temperature is increased. In a case where the determination is "C", a CPU is not operated because it is not possible to dissipate generated heat.

Regarding determination criteria of flexibility, a section was observed after the heat conductivity was evaluated. A case where cracks did not occur in the bonding material layer or the compound layer was set to be "α". A case where cracks occurred in the bonding material layer or the compound layer was set to be "B".

**[Table 1]**

| | Thickness (mm) of bonded member | First element | Content (wt%) of first element | Thickness (µm) of compound layer | Composition ratio of compound layer First element/tin/carbon (wt%/wt%/wt%) | Temperature difference (°C) | Decrease rate (%) | Heat conductivity | Flexibility |
|---|---|---|---|---|---|---|---|---|---|
| Example 1 | 0.1 | Titanium | 0.1 | 0.4 | 55/10/35 | 12.7 | 5.8 | A | α |
| Example 2 | 0.1 | Titanium | 2 | 6 | 68/5/27 | 13 | 8.3 | A | α |
| Example 3 | 0.1 | Titanium | 5 | 10 | 80/1/19 | 13.5 | 12.5 | B | α |
| Example 4 | 0.5 | Titanium | 0.1 | 0.1 | 50/15/35 | 3.2 | 6.7 | A | α |
| Example 5 | 0.5 | Titanium | 1 | 3 | 64/7/29 | 3.3 | 10 | A | α |
| Example 6 | 0.5 | Titanium | 5 | 9 | 80/5/15 | 3.4 | 13.3 | B | α |
| Example 7 | 0.1 | Zirconium | 0.1 | 0.3 | 53/13/34 | 12.9 | 7.5 | A | α |
| Example 8 | 0.5 | Vanadium | 5 | 10 | 80/3/17 | 3.4 | 13.3 | B | α |
| Example 9 | 0.1 | Titanium /Zirconium | 0.5/0.5 | 3 | 63/7/30 | 12.9 | 7.5 | A | α |
| Example 10 | 0.1 | Titanium /Vanadium | 0.05/0.05 | 0.1 | 51/14/35 | 12.8 | 6.7 | A | α |
| Example 11 | 0.1 | Zirconium /Vanadium | 2.5/2.5 | 10 | 80/2/18 | 13.6 | 13 | B | α |
| Example 12 | 0.1 | Titanium /Zirconium /Vanadium | 1/1/1 | 7 | 73/4/23 | 13.1 | 9.2 | A | α |
| Comparative Example 1 | 0.2 | None | - | - | - | 12 | - | - | - |
| Comparative Example 2 | 1 | None | - | - | - | 3 | - | - | - |
| Comparative Example 3 | 0.1 | Titanium | 0.05 | 0 | 0/0/0 | 17 | 41.7 | C | α |
| Comparative Example 4 | 0.1 | Titanium | 5.5 | 11 | 82/0.5/17.5 | 16 | 33.3 | C | β |

In the bonded body in each of Examples 1 to 3, the thickness of the bonded member was 0.1 mm, and the titanium content of the bonding material was at least 0.1 wt% to at most 5 wt%. The temperature difference of such a bonded body was 12.7°C to 13.5°C and the decrease rate was 5.8% to 12.5%. This was a result which was substantially equivalent to the temperature difference of 12°C in Comparative Example 1 in which the bonding material was not used and only a carbon material was used. Thus, favorable heat transferability was obtained. Even in a case of the result obtained by observing the section, cracks were not viewed in the bonding material layer or the compound layer.

In the bonded body in each of Examples 4 to 6, the thickness of the bonded member was 0.5 mm, and the titanium content of the bonding material was at least 0.1 wt% to at most 5 wt%. The temperature difference of such a bonded body was 3.2°C to 3.4°C and the decrease rate was 6.7% to 13.3%. This was a result which was substantially equivalent to the temperature difference of 3°C in Comparative Example 2 in which the bonding material was not used and only a carbon material was used. Thus, favorable heat transferability was obtained. Even in a case of the result obtained by observing the section, cracks were not viewed in the bonding material layer or the compound layer.

In the bonded body in each of Comparative Examples 3 and 4, the thickness of the bonded member was 0.1 mm, and the titanium content of the bonding material was 0.05 wt% in Comparative Example 3 and 5.5 wt% in Comparative Example 4. The temperature difference of the bonded body was 17°C in Comparative Example 3 and 16°C in Comparative Example 4. The decrease rate was 41.7% in Comparative Example 3 and 33.3% in Comparative Example 4. As the result obtained by observing the section, in Comparative Example 3, the bonding material had multiple voids without being wet by the carbon material. Thus, it is considered that the heat conductivity in Comparative Example 3 is largely decreased in comparison to that in Comparative Example 1. In Comparative Example 4, as the result obtained by observing the section, cracks were not viewed. When the observation is performed by an electron microscope, compound layer 105 is formed to exceed 11 µm. Thus, it is considered that the thickness of the bonding material layer including much Sn is small, flexibility of the junction is lost, and cracks occur. It is considered that the heat conductivity is largely reduced because cracks occur.

In the bonded body in Example 7, 0.1 wt% of zirconium as the compound-formable element was used, and the thickness of the bonded member was 0.1 mm. The temperature difference of such a bonded body was 12.9°C and the decrease rate was 7.5%. This was a result which was substantially equivalent to the temperature difference of 12°C in Comparative Example 1 in which the bonding material was not used and only a carbon material was used. Thus, favorable heat transferability was obtained. Cracks were not viewed in the bonding material or a bonding layer even from the result obtained by observing the section.

In the bonded body in Example 8, 5 wt% of vanadium as the compound-formable element was used, and the thickness of the bonded member was 0.5 mm. The temperature difference of such a bonded body was 3.4°C and the decrease rate was 13.3%. This was a result which was substantially equivalent to the temperature difference of 3°C in Comparative Example 2 in which the bonding material was not used and only a carbon material was used. Thus, favorable heat transferability was obtained. Cracks were not viewed in the bonding material or a bonding layer even from the result obtained by observing the section.

In the bonded body in each of Examples 9 to 12, plural kinds of compound-formable elements for forming a compound along with tin and carbon were used so as to cause the total content thereof to be at least 0.1 wt% to at most 5 wt%, and the thickness of the bonded member was 0.1 mm. The temperature difference of such a bonded body was 12.8°C to 13.6°C and the decrease rate was 6.7% to 13%. Thus, favorable heat transferability as much as the performance of a CPU was not degraded even when the bonded body was used as a heat dissipation member, in a product. Even in a case of the result obtained by observing the section, cracks were not viewed in the bonding material layer or the compound layer.

The junction provided by the bonding material in the disclosure is firm, has heat dissipation properties, and has flexibility. Thus, it is possible to be also used in a heat generated portion in a semiconductor, industrial equipment, and the like.

## Claims

1. A manufacturing method of a bonded body (104), the method comprising:
a step of preparing a first member (101), a second member (102), and a film-shaped bonding material (103),
wherein each of the first member (101) and the second member (102) is a carbon material and wherein the film-shaped bonding material (103) includes at least 0.1 wt% to at most 5 wt% of at least one element which can form a compound along with tin and carbon,
wherein elements which can form a compound along with tin and carbon are selected from the group consisting of Ti, V and Zr, and
wherein the total amount of elements which can form a compound along with tin and carbon is at least 0.1 wt% to at most 5 wt%, to the total weight of the film-shaped bonding material (103); and Sn as single remainder;
a step of bonding the first member (101) and the second member (102) to each other, the bonding step including:
disposing the film-shaped bonding material (103) between the first member (101) and the second member (102);
hot pressing on first member (101), second member (102), and bonding material (103) under a nitrogen atmosphere at 250°C or higher and 1500°C or lower for a suitable time;
and then cooling;
thereby forming a junction (107) configured by a bonding material layer (106) and compound layer (105),
wherein the compound layer (105) is configured from a compound of the at least one element, tin, and carbon, at an interface between the first member (101) and the bonding material layer (106) and an interface between the second member (102) and the bonding material layer (106).

2. A bonded body (104) obtainable by the method of claim 1, comprising:
a first member (101);
a second member (102); and
a junction (107) which is provided between the first member (101) and the second member (102),
wherein each of the first member (101) and the second member (102) is a carbon material,
wherein the junction (107) includes:
a bonding material layer (106),
a first compound layer (105) formed at an interface between the first member (101) and the bonding material layer (106),
a second compound layer (105) formed at an interface between the second member (102) and the bonding material layer (106),
wherein the junction (107) contains at least one of titanium, zirconium, and vanadium as a compound-formable element and Sn as a main component, and
wherein the first and second compound layers (105) have a concentration of the compound-formable element higher than the concentration of the compound-formable element in the bonding material layer (106).

3. The bonded body of Claim 2,
wherein each of the first and second compound layers (105) has a thickness of 0.1 µm to 10 µm, inclusive.

## Patentansprüche

1. Verfahren zur Herstellung eines Verbundkörpers (104), wobei das Verfahren umfasst:
einen Schritt des Herstellens eines ersten Elements (101), eines zweiten Elements (102) und eines filmförmigen Bindungsmaterials (103),
wobei jedes von dem ersten Element (101) und dem zweiten Element (102) ein Kohlenstoffmaterial ist und wobei das filmförmige Bindungsmaterial (103) mindestens 0,1 Gew.-% bis höchstens 5 Gew.-% von mindestens einem Element umfasst, das gemeinsam mit Zinn und Kohlenstoff eine Verbindung bilden kann,
wobei Elemente, die gemeinsam mit Zinn und Kohlenstoff eine Verbindung bilden können, ausgewählt werden aus der Gruppe, die besteht aus Ti, V und Zr, und
wobei die Gesamtmenge von Elementen, die gemeinsam mit Zinn und Kohlenstoff eine Verbindung bilden können, mindestens 0,1 Gew.-% bis höchstens 5 Gew.-% beträgt, bezogen auf das Gesamtgewicht des filmförmigen Bindungsmaterials (103); und Sn als einzigen Rests;
einen Schritt des Verbindens des ersten Elements (101) und des zweiten Elements (102) miteinander, wobei der Verbindungsschritt umfasst:
Anordnen des filmförmigen Bindungsmaterials (103) zwischen dem ersten Element (101) und dem zweiten Element (102) ;
Heißpressen auf dem ersten Element (101), dem zweiten Element (102) und dem Bindungsmaterial (103) unter einer Stickstoffatmosphäre bei 250 °C oder höher und 1500 °C oder niedriger während einer geeigneten Zeit;
und dann Kühlen;
dadurch Bilden eines Übergangs (107), der durch eine Bindungsmaterialschicht (106) und eine Verbindungsschicht (105) ausgestaltet ist,
wobei die Verbindungsschicht (105) aus einer Verbindung des mindestens einen Elements, Zinn und Kohlenstoff an einer Grenzfläche zwischen dem ersten Element (101) und der Bindungsmaterialschicht (106) und einer Grenzfläche zwischen dem zweiten Element (102) und der Bindungsmaterialschicht (106) ausgestaltet ist.

2. Verbundkörper (104), der durch das Verfahren nach Anspruch 1 erhältlich ist, umfassend:
ein erstes Element (101);
ein zweites Element (102); und
einen Übergang (107), der zwischen dem ersten Element (101) und dem zweiten Element (102) bereitgestellt ist,
wobei jedes von dem ersten Element (101) und dem zweiten Element (102) ein Kohlenstoffmaterial ist,
wobei der Übergang (107) umfasst:
eine Bindungsmaterialschicht (106),
eine erste Verbindungsschicht (105), die an einer Grenzfläche zwischen dem ersten Element (101) und der Bindungsmaterialschicht (106) gebildet ist,
eine zweite Verbindungsschicht (105), die an einer Grenzfläche zwischen dem zweiten Element (102) und der Bindungsmaterialschicht (106) gebildet ist,
wobei der Übergang (107) mindestens eines von Titan, Zirconium und Vanadium als ein verbindungsbildbares Element und Sn als eine Hauptkomponente enthält, und
wobei die erste und die zweite Verbindungsschicht (105) eine Konzentration des verbindungsbildbaren Elements aufweisen, die höher als die Konzentration des verbindungsbildbaren Elements in der Bindungsmaterialschicht (106) ist.

3. Verbundkörper nach Anspruch 2,
wobei jede von der ersten und der zweiten Verbindungschicht (105) eine Dicke von einschließlich 0,1 µm bis 10 µm aufweist.

## Revendications

1. Procédé de fabrication d'un corps lié (104), le procédé comprenant :
une étape de préparation d'une première pièce (101), d'une deuxième pièce (102), et d'un matériau de liaison en forme de film (103),
dans lequel chacune parmi la première pièce (101) et la deuxième pièce (102) est un matériau carboné et dans lequel le matériau de liaison en forme de film (103) contient d'au moins 0,1 % en poids à au plus 5 % en poids d'au moins un élément qui peut former un composé conjointement avec de l'étain et du carbone,
dans lequel les éléments qui peuvent former un composé conjointement avec de l'étain et du carbone sont choisis dans le groupe constitué par Ti, V et Zr, et
dans lequel la quantité totale des éléments qui peuvent former un composé conjointement avec de l'étain et du carbone est d'au moins 0,1 % en poids à au plus 5 % en poids par rapport au poids total du matériau de liaison en forme de film (103) ; et du Sn en tant que seul autre élément ;
une étape de liaison de la première pièce (101) et de la deuxième pièce (102) l'une à l'autre, l'étape de liaison comprenant :
la disposition du matériau de liaison en forme de film (103) entre la première pièce (101) et la deuxième pièce (102) ;
le pressage à chaud, sur la première pièce (101), de la deuxième pièce (102) et du matériau de liaison (103) dans une atmosphère d'azote à 250°C ou plus et 1500°C ou moins pendant un temps convenable ;
et ensuite le refroidissement ;
ce qui forme ainsi une jonction (107) configurée par une couche de matériau de liaison (106) et une couche de composé (105),
dans lequel la couche de composé (105) est configurée à partir d'un composé de l'au moins élément, d'étain et de carbone, au niveau d'une interface entre la première pièce (101) et la couche de matériau de liaison (106) et d'une interface entre la deuxième pièce (102) et la couche de matériau de liaison (106).

2. Corps lié (104) susceptible d'être obtenu par le procédé de la revendication 1, comprenant :
une première pièce (101) ;
une deuxième pièce (102) ; et
une jonction (107) qui est disposée entre la première pièce (101) et la deuxième pièce (102),
dans lequel chacune parmi la première pièce (101) et la deuxième pièce (102) est un matériau carboné,
dans lequel la jonction (107) comprend :
une couche de matériau de liaison (106),
une première couche de composé (105) formée au niveau d'une interface entre la première pièce (101) et la couche de matériau de liaison (106),
une deuxième couche de composé (105) formée au niveau d'une interface entre la deuxième pièce (102) et la couche de matériau de liaison (106),
dans lequel la jonction (107) contient au moins l'un parmi le titane, le zirconium et le vanadium en tant qu'élément pouvant former un composé, et du Sn en tant que composant principal, et
dans lequel les première et deuxième couches de composé (105) ont une concentration de l'élément pouvant former un composé supérieure à la concentration de l'élément pouvant former un composé dans la couche de matériau de liaison (106).

3. Corps lié selon la revendication 2, dans lequel chacune parmi les première et deuxième couches de composé (105) a une épaisseur de 0,1 µm à 10 µm, bornes comprises.
